# EUROPEAN PATENT SPECIFICATION

(11) **EP 1 029 944 B1**
(45) Date of publication and mention of the grant of the patent: **03.03.2010**
(21) Application number: 00300182.3
(22) Date of filing: 12.01.2000
(51) Int. Cl.: C23C 18/42, H05K 3/24, B23K 35/00

(54) **Method for enhancing the solderability of a surface**
Verfahren zur Verbesserung der Lötbarkeit einer Oberfläche
Procédé pour améliorer la soudabilité d'une surface

(30) Priority: 17.02.1999 US 251641
(43) Date of publication of application: 23.08.2000
(73) Proprietor: MACDERMID INCORPORATED, Waterbury, Connecticut 06702 (US)
(72) Inventor: Redline, Ronald, Prospect, CT (US); Sawoska, David, Watertown, CT (US); Kukanskis, Peter, Woodbury, CT (US)
(74) Representative: Jenkins, Peter David

(56) References cited:
- EP-A- 0 797 380
- WO-A-96/17975
- GB-A- 2 201 163
- US-A- 5 733 599

## Description

This invention relates generally to a method of treating a surface which treatment enhances the solderability of the surface. The method is particularly useful in the fabrication and assembly of printed circuit boards.

Soldering is generally used for making mechanical, electromechanical, or electronic connections to a variety of articles. The distinction between expected functions of the joints is important because each application has its own specific requirements for surface preparation. Of the three soldering applications, making electronic connections is the most demanding.

In the manufacture of electronic equipment utilizing printed circuits, connections of electronic components to the printed circuits are made by soldering of the leads of the components to the through-holes, surrounding pads, lands and other points of connection (collectively, "Areas of Connection"). Typically the connection occurs by wave soldering techniques.

To facilitate this soldering operation, the printed circuit fabricator is required to arrange that the through-holes, pads, lands and other points of connection are receptive to the subsequent soldering processes. Thus these surfaces must be readily wettable by the solder and permit an integral conductive connection with the leads or surfaces of the electronic components. Because of these needs, printed circuit fabricators have devised various methods of preserving and enhancing the solderability of surfaces.

One means of arranging good solderability of the surfaces in question is to provide the surfaces with a pre-coating of solder. This is typically performed by a process called hot air solder leveling or through some type of plating process. In printed circuit fabrication, however, this method has several drawbacks. The use of hot air solder leveling may cause unacceptably high rate of defects due to shorts, particularly when dealing with small circuits. If plating is used, since it is not easy to selectively provide these areas with solder, all conductive areas of the board must be solder plated causing severe problems with the subsequent application of solder mask. In addition the foregoing processes are inefficient and relatively expensive.

Another means of arranging good solderability of these surfaces is to plate them with a final finish coating of a precious metal such as gold, palladium or rhodium. U.S. Patent No. 5,235,139 (Bengston, et. al.) proposes a method for achieving this previous metal final finish. Bengston et. al. propose plating the copper areas to be soldered with electroless nickel-boron, followed by a precious metal coating such as gold. See also US Patent No. 4,940,181 to Juskey, Jr. et al. for a similar process which teaches the plating of electroless copper, followed by electrolytic copper, followed by nickel followed by gold as a solderable surface. These processes work well but are time consuming and expensive.

Various attempts have been made to selectively apply solder to the necessary areas only. One such method involves use of organic etch resists over the solder plated areas of connection followed by selective stripping of tin-lead from the copper traces before application of the solder mask. See US Patent No. 4,978,423 to Durnwith et. al. See also US Patent No. 5,160,579 to Larson for other known selective solder processes.

Soldering directly to copper surfaces has been difficult and inconsistent. These problems are due mainly to the inability of keeping the copper surfaces clean and free of oxidation throughout the soldering operation. Various organic treatments have been developed to preserve copper surfaces in a readily solderable state. For example, see US Patent No. 5,173,130 (Kinoshita) which teaches the use of certain 2-alkylbenzimidazoles as copper pre-fluxes to preserve the solderability of the copper surfaces. Treatments such as those taught in Kinoshita have proven successful but there is still need to improve the reliability of the process.

GB-A-2201163 discloses electroless silver plating composition including suspending agents comprising a stearic acid/triethanolamine adduct.

WO96/17975 discloses a process for providing a tarnish-resistant and solderable coating and plating compositions for use in the process. The plating compositions including tarnish inhibitors such as fatty acid amines.

EP-A-079380 discloses an immersion silver composition comprising an imidazole or imidazole derivative which brightens the plated deposit and improves the integrity and physical properties of the resultant plated deposit.

US 5,733,599 also discloses an immersion silver composition comprising an imidazole or imidazole derivative.

The method of preserving solderability proposed herein is the coating of copper surfaces to be soldered with an immersion silver plate prior to soldering. It has been found, however, that when the foregoing method is used the immersion silver coating has a tendency to develop outgrowths or filaments via an electromigration mechanism when the circuits are being used (ie. with voltage potentials present) in the presence of moisture.

The tendency for electromigration to occur can be measured by a standard technique specified in Bellcore GR-78-CORE (13.2.5, 13.2.7) standard test procedures.

The foregoing Bellcore procedure measures the average insulation resistance between circuit features. Bellcore and IPC standards require, that the average insulation resistance not decrease by more than one decade between the initial value (obtained after a conditioning period of 96 hours at 85°C/85% relative humidity with no bias) and the final value (obtained after an additional 500 hours at 85°C/85% relative humidity with a 10 V.de bias applied).

One method which may be used to overcome the electromigration of immersion silver plating is to coat the immersion silver plate with another more noble metal such as gold. The disadvantages of this method are the expense of gold plating as well as the necessity for additional process steps.

It is an object of this invention to propose a method for preserving and enhancing the solderability of copper surfaces by plating said copper surface with a novel immersion silver plate which is more resistant to electromigration than prior art immersion silver deposits.

The current invention proposes the use of an immersion silver coating as an improved solderability preservative for various surfaces, particularly copper surfaces. Preferred compositions for depositing the immersion silver coating are also disclosed. The novel immersion silver plating process produces a silver plate which is more resistant to electromigration than conventional immersion silver deposits. The process proposed is a versatile, low cost method for effectively preserving the solderability of surfaces, particularly copper surfaces and areas of connection on printed circuit boards.

According to a first aspect of the present invention there is provided a process for improving the solderability of a copper surface, said process comprising treating the copper surface with an immersion silver plating solution, said solution comprising: a) a soluble source of silver ions; b) an acid; c) an aromatic nitro compound; and characterised by d) an additive selected from the group consisting of ethoxylated tallowamine, ethoxylated cocoamine, tallowamine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

According to a second aspect of the present invention there is provided a process for improving the solderability of a copper surface, said process comprising: (a) contacting the copper surface with an immersion silver plating solution thereby producing an immersion silver plate upon the copper surface, wherein the immersion silver plating solution comprises a soluble source of silver ions, an acid, and an aromatic nitro compound; and thereafter characterised by: (b) treating the immersion silver plated metal surface with a solution comprising an additive selected from the group consisting of ethoxylated tallowamine, ethoxylated cocoamine, tallow amine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

According to a third aspect of the present invention there is provided an immersion silver plating solution comprising: a) an aromatic nitro compound; and characterised by b) an additive selected from the group consisting of ethoxylated tallowamine, ethoxylated cocoamine, tallow amine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

It has been discovered that immersion silver deposits provide excellent solderability preservatives, which are particularly useful in the fabrication of printed circuit boards. The solderability achievable with a simple immersion silver deposit in printed circuit applications has unexpectedly been found to exceed that achievable with prior art nickel-gold plating processes such as described in U.S. Patent No. 5,235,139 and unexpectedly exceeds that achievable with other immersion deposits. As can be seen in the examples to follow, the processes of the current invention yield surfaces which are very solderable under adverse conditions. In printed circuit applications the surfaces are wire bondable. In addition the incorporation of an additive selected from the group consisting of ethoxylated tallowamine, ethoxylated cocoamine, tallowamine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing into the immersion silver deposit by incorporation in the plating bath or subsequent treatment of the plated surface greatly reduces the tendency of the silver deposit to electromigrate. Immersion plating is a process which results from a replacement reaction whereby the surface being plated dissolves into solution and at the same time the metal being plated deposits from the plating solution onto the surface. The immersion plating initiates without prior activation of the surfaces. The metal to be plated is generally more noble than the surface metal. Thus immersion plating is usually significantly easier to control and significantly more cost effective than electroless plating, which requires sophisticated auto catalytic plating solutions and processes for activation of the surfaces prior to plating.

The soluble source of silver ions can be derived from a variety of silver compounds. The inventors have found silver nitrate to be most preferable. The concentration of silver in the plating solution can range from 0.1 to 25 grams per liter, but is most preferably present in a concentration of 0.5 to 2 grams per liter.

Although a variety of acids are suitable for use in this formulation, the inventors have found that methane sulfonic acid or nitric acid is most preferred. The concentration of acid in the plating solution can range from 1 to 150 grams per liter but is preferably in the range of to 50 grams per liter.

In order to prevent or significantly reduce the tendency for immersion silver plates to electromigrate in the application proposed, the inventors have found it necessary to incorporate certain additives into the plated deposit, either by incorporation of the additives in the plating bath itself or by subsequent treatment of the plated surface with the additives. Incorporation of the additives into the plating bath itself is the preferred method. The additives may be selected from the group consisting of tallowamine, ethoxylated cocoamine, tallowamine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing

The concentration of the foregoing additives in the immersion silver plating bath or in the subsequent surface treatment composition may range from 0.1 to 15 grams per liter but is preferably from 1 to 5 grams per liter.

In certain embodiments of the present invention, as a further advantage the inventors have discovered that the inclusion of imidazole or imidazole derivative of the following formula has a significant positive impact upon the plate produced by immersion plating solutions, particularly immersion silver plating solutions used in the processes of these embodiments of this invention

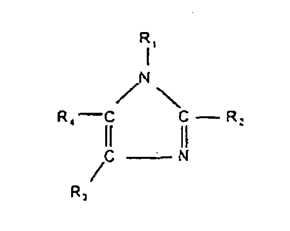

Wherein R₁, R₂, R₃ and R₄ are independently selected from the group consisting of substituted or unsubstituted alkyl groups, substituted or unsubstituted aryl groups, halogens, nitro groups and hydrogen.

The inclusion of an imidazole as described in the embodiments above brightens the plated deposit and improves the integrity and physical properties of the resultant plated deposit. In addition, the imidazole also extends the useful life of the immersion plating solution. The inventors have found that histidine is a particularly preferred imidazole for the purposes of these processes.

The inclusion of imidazoles in these embodiments provides significant further advantages in immersion plating solutions in general, but is particularly useful and advantageous in immersion silver plating. As one further advantage, the inventors have found that immersion silver deposits resulting from plating baths containing imidazoles are brighter, smoother and more cohesive than immersion silver deposits plated from baths which do not have imidazoles. As an additional advantage, the immersion plating bath with imidazoles have longer effective lives than comparable baths without imidazoles. These same advantages are achievable by the inclusion of imidazoles in other immersion plating baths, including copper, palladium, gold, ruthenium and rhodium.

With respect to the immersion silver compositions useful in the present invention, the plating solution also contains an oxidant in the form of an aromatic nitro compound. The inventors have found that dinitro compounds, such as 3,5 dinitrohydroxybenzoic acid are preferred in this regard. The concentration of such an oxidant in the solution can range from 0.1 to 25 grams per litre, but is preferably from 0.2 to 2 grams per litre.

The immersion silver solution can be used in the processes of the current invention at temperatures ranging from room temperature to 93.3°C (200°F) but is preferably used at from 26.7°C to 48.9°C (80 to 120°F). The time for immersion in the plating solution can range from 1 to 30 minutes but is preferably from 1 to 5 minutes.

The immersion silver solution of the current invention is thus used to plate a thin layer of silver onto the surface to be soldered. It is believed that the resultant silver coating should be from 0.002µm to 2.54 µm (1 to 100 micro inches) thick, preferably from 0.25µm to 1.52µm (10 to 60 micro inches) thick for effective enhancement and preservation of the solderability of the surface. Although this process is effective in soldering many surfaces, it is particularly useful in soldering copper surfaces, such as Areas of Connection on printed circuit boards.

Although this technique may be utilized advantageously over almost any surface, it is most useful in the fabrication of printed circuit boards, particularly solder mask over bare copper (SMOBC) boards. Thus, in fabricating SMOBC boards, the solder mask is applied to the surfaces of the board then exposed and developed to reveal the Areas of Connection. These Areas of Connection are then essentially the only exposed areas of copper on the board, with the remainder essentially being covered by solder mask. These exposed Areas of Connection are thus destined to be points of attachment, in most cases by soldering, when the electronic components are later placed on the board later in the fabrication cycle. Therefore, the solderability of these exposed points, generally copper, must be enhanced and preserved.

Thus according to the current invention these areas are then preferably cleaned, using an acid cleaner, and subsequently microetched to prepare the surface for acceptable immersion plating. Following this preferred preparation, the board is immersed in the immersion silver plating solution, such that a silver deposit of appropriate thickness is achieved.

The invention is further described for illustrative purposes only in the following examples which are in no way limiting of the invention itself. In each of the examples standard IPC-B-25 test circuit boards are utilized in order to provide consistency. IPC-B-25 standard is incorporated herein by reference in its entirety

### Example I

IPC-B-25 test circuit boards were processed with the following steps:
a). Acid Cleaner, 5 minutes, 48.9°C (120°F)
b). Water Rinse
c). Sodium persulfate/sulphuric acid microetch, 1 minute, 35.0°C (95°F)
d). Water rinse
e). Water rinse
f). Immersion silver plate using the following composition

| | |
|---|---|
| hydroxy ethylenediamine tetraacetic acid | 10 gr/l |
| silver nitrate | 2.4 gr/l |
| igepal Co730 | 5.0 gr/l |
| imidazole | 10 gr/l |
| nitric acid | 32.0 ml/l |

g). water rinse.

The circuit boards were then tested according to the Bellcore GR-78-Core (13.2.5. 13.2.7) standard test method.

### Example II

IPC-B-25 test circuit boards were treated as noted in Example I except that in this case the immersion silver plating bath also contained 5.0 gr/l of tallow amine ethoxylated with 15 moles of ethylene oxide. The circuit boards were then tested according to the Belcore GR-78-Core (13.2.5, 13.2.7) standard test method.

### Example III

IPC-B-25 test circuit boards were treated as noted in Example 1 except that in this case the immersion silver plating bath also contained 1.1 g/l of Pamak 25-S which is available from Hercules, Incorporated of Wilmington, Delaware and is a blend of fatty and resinous acids. The circuit boards were then tested according to Belcore GR-78-Core (13.2.5, 13.2.7) standard test method.

### Example IV

IPC-B-25 test circuit boards were treated as noted in Example 1 except in this case after step (g) the circuit boards were further processed as follows:
h). treatment with an aqueous solution containing:
   5.0 gr./l Cyastat L5 (quaternary ammonium methylsulfate of a fatty amidoalkyl amine)
   32 ml/l Nitric Acid (70%)
   balance - water.
i). water rinse.

The circuit boards were then tested according to Belcore GR-78-Corc (13.2.5, 13.2.7) standard test method.

### Example V

IPC-B-25 test circuit boards were treated as noted in Example IV except that in this case the Cyastat LS was replaced with 5.0 gr/l Cocoamine ethoxylated with 2 moles of ethylene oxide. The circuit boards were then tested according to Belcore GR-78-Core (13.2.5, 13.2.7) standard test method.

## Claims

1. A process for improving the solderability of a copper surface, said process comprising treating the copper surface with an immersion silver plating solution, said solution comprising:
a) a soluble source of silver ions;
b) an acid;
c) an aromatic nitro compound; and **characterised by**
d) an additive selected from the group consisting of ethoxylated tallowamine, ethoxylated cocoamine, tallowamine, coco amine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

2. A process according to claim 1 wherein the silver plating solution also comprises material selected from the group consisting of imidazoles, benzimidazoles, imidazole derivatives and benzimidazoles derivatives.

3. A process for improving the solderability of a copper surface, said process comprising:
(a) contacting the copper surface with an immersion silver plating solution thereby producing an immersion silver plate upon the copper surface, wherein the immersion silver plating solution comprises a soluble source of silver ions, an acid, and an aromatic nitro compound; and thereafter **characterised by**:
(b) treating the immersion silver plated metal surface with a solution comprising an additive selected from the group consisting of ethoxylated tallowamine, ethoxylated cocoamine, tallow amine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

4. A process according to claim 3 wherein the silver plating solution comprises a material selected from the group consisting of imidazoles, benzimidazoles, imidazole derivatives and benzimidazoles derivatives.

5. An immersion silver plating solution comprising:
a) an aromatic nitro compound; and **characterised by**
b) an additive selected from the group consisting of ethoxylated tallowamine, ethoxylated cocoamine, tallow amine, cocoamine, amines derived from tall oil acids, ethoxylated amines derived from tall oil acids, stearic acid, oleic acid, palmitic acid, acids derived from the distillation of tall oil, (stearamidopropyl) dimethyl hydroxyethylammonium dihydrogen phosphate, alkyliminodipropionic acid monosodium salts, and mixtures of the foregoing.

6. An immersion plating solution according to claim 5 also comprising a material selected from the group consisting of imidazoles, benzimidazoles, imidazole derivatives, and benzimidazoles derivatives.

## Patentansprüche

1. Verfahren zum Verbessern der Lötbarkeit einer Kupferoberfläche, wobei das Verfahren ein Behandeln der Kupferoberfläche mit einer Immersionssilberplattierlösung umfasst, wobei die Lösung umfasst:
a) eine lösliche Quelle von Silberionen;
b) eine Säure;
c) eine aromatische Nitroverbindung; und **gekennzeichnet durch**
d) ein Additiv, das aus der Gruppe ausgewählt ist, die aus ethoxyliertem Talgamin, ethoxyliertem Cocoamin, Talgamin, Cocoamin, von Tallölsäuren abgeleitete Amine, ethoxylierte Amine, die von Tallölsäuren, Stearinsäure, Ölsäure, Palmitinsäure, von der Destillation von Tallöl abgeleitete Säuren abgeleitet sind, (Stearamidopropyl)dimethylhydroxyethylammoniumdihydrogenphosphat, Alkyliminodipropionsäure-Mononatriumsalze und Mischungen der vorgenannten besteht

2. Verfahren gemäß Anspruch 1, wobei die Silberplattierlösung auch Material umfasst, das aus der Gruppe ausgewählt ist, die aus Imidazolen, Benzimidazolen, Imidazolderivaten und Benzimidazolderivaten besteht.

3. Verfahren zum Verbessern der Lötbarkeit einer Kupferoberfläche, wobei das Verfahren umfasst:
(a) Kontaktieren der Kupferoberfläche mit einer Immersionssilberplattierlösung, wodurch eine Immersionssilberplatte auf der Kupferoberfläche erzeugt wird, wobei die Immersionssilberplattierlösung eine lösliche Quelle von Silberionen, eine Säure und eine aromatische Nitroverbindung umfasst; und danach **gekennzeichnet ist durch**:
(b) Behandeln der immersionssilberplattierten Metalloberfläche mit einer Lösung, die ein Additiv umfasst, das aus der Gruppe ausgewählt ist, die aus ethoxyliertem Talgamin, ethoxyliertem Cocoamin, Talgamin, Cocoamin, von Tallölsäuren abgeleitete Amine, ethoxylierte Amine, die von Tallölsäuren, Stearinsäure, Ölsäure, Palmitinsäure, von der Destillation von Tallöl abgeleitete Säuren abgeleitet sind, (Stearamidopropyl)dimethylhydroxyethylammoniumdihydrogenphosphat, Alkyliminodipropionsäure-Mononatriumsalze, und Mischungen der vorgenannten besteht

4. Verfahren gemäß Anspruch 3, wobei die Silberplattierlösung ein Material umfasst, das aus der Gruppe ausgewählt ist, die aus Imidazolen, Benzimidazolen, Imidazolderivaten und Benzimidazolderivaten besteht.

5. Immersionssilberplattierlösung, welche umfasst:
a) eine aromatische Nitroverbindung; und **gekennzeichnet durch**
b) ein Additiv, das aus der Gruppe ausgewählt ist, die aus ethoxyliertem Talgamin, ethoxyliertem Cocoamin, Talgamin, Cocoamin, von Tallölsäuren abgeleitete Amine, ethoxylierte Amine, die von Tallölsäuren, Stearinsäure, Ölsäure, Palmitinsäure, von der Destillation von Tallöl abgeleitete Säuren abgeleitet sind, (Stearamidopropyl)dimethylhydroxyethylammoniumdihydrogenphosphat, Alkyliminodipropionsäure-Mononatriumsalze und Mischungen der vorgenannten besteht.

6. Immersionssilberplattierlösung gemäß Anspruch 5, welche auch ein Material umfasst, das aus der Gruppe ausgewählt ist, die aus Imidazolen, Benzimidazolen, Imidazolderivaten und Benzimidazolderivaten besteht.

## Revendications

1. Procédé d'amélioration de la soudabilité d'une surface de cuivre, le procédé comprenant le traitement de la surface de cuivre par une solution de dépôt d'argent par immersion, la solution comprenant :
a) une source soluble d'ions argent ;
b) un acide ;
c) un composé azoté aromatique ; et **caractérisé par**
d) un additif choisi dans le groupe comprenant l'amine de suif éthoxylée, la cocoamine éthoxylée, l'amine de suif, la cocoamine, des amines obtenues à partir d'acides de tallöl, des amines éthoxylées obtenues à partir d'acides de tallöl, d'acide stéarique, d'acide oléique, d'acide palmitique, d'acides obtenus à partir de la distillation de tallöl, le dihydrogénophosphate de (stéaramidopropyl) diméthyl hydroxyéthylammonium, des sels monosodiques d'acide alkyliminodipropionique, et leurs mélanges.

2. Procédé selon la revendication 1, dans lequel la solution de dépôt d'argent comprend aussi un matériau choisi dans le groupe comprenant des imidazole, des benzimidazoles, des dérivés d'imidazoles et des dérivés de benzimidazoles.

3. Procédé d'amélioration de la soudabilité d'une surface de cuivre, le procédé comprenant :
(a) mettre en contact la surface de cuivre avec une solution de dépôt d'argent par immersion, produisant ainsi un dépôt d'argent par immersion sur la surface de cuivre, la solution de dépôt d'argent par immersion comprenant une source soluble d'ions argent, un acide, et un composé azoté aromatique ; et **caractérisé en**suite par :
(b) traiter la surface métallique de dépôt d'argent par immersion à l'aide d'une solution comprenant un additif choisi dans le groupe comprenant l'amine de suif éthoxylée, la cocoamine éthoxylée, l'amine de suif, la cocoamine, des amines obtenues à partir d'acides de tallôl, des amines éthoxylées obtenues à partir d'acides de tallöl, d'acide stéarique, d'acide oléique, d'acide palmitique, d'acides obtenus à partir de la distillation de tallöl, le dihydrogénophosphate de (stéaramidopropyl) diméthyl hydroxyéthylammonium, des sels monosodiques d'acide alkyliminodipropionique, et leurs mélanges.

4. Procédé selon la revendication 3, dans lequel la solution de dépôt d'argent comprend un matériau choisi dans le groupe comprenant des imidazoles, des benzimidazoles, des dérivés d'imidazoles et des dérivés de benzimidazoles.

5. Solution de dépôt d'argent par immersion comprenant:
a) un composé azoté aromatique ; et **caractérisé par**
b) un additif choisi dans le groupe comprenant l'amine de suif éthoxylée, la cocoamine éthoxylée, l'amine de suif, la cocoamine, des amines obtenues à partir d'acides de tallöl, des amines éthoxylées obtenues à partir d'acides de tallöl, d'acide stéarique, d'acide oléique, d'acide palmitique, d'acides obtenus à partir de la distillation de tallöl, le dihydrogénophosphate de (stéaramidopropyl) diméthyl hydroxyéthylammonium, des sels monosodiques d'acide alkyliminodipropionique, et leurs mélanges.

6. Solution de dépôt par immersion selon la revendication 5, comprenant aussi un matériau choisi dans le groupe comprenant des imidazoles, des benzimidazoles, des dérivés d'imidazoles et des dérivés de benzimidazoles.
